# FASCICULE DE BREVET EUROPEEN

(11) **EP 0 381 596 B1**
(45) Date de publication et mention de la délivrance du brevet: **29.12.1993**
(21) Numéro de dépôt: 90420042.5
(22) Date de dépôt: 30.01.1990
(51) Int. Cl.: G01R 27/26, G01R 31/26

(54) **Procédé et appareil de mesure de capacités de faible valeur**
Verfahren und Apparatur zur Messung von kleinen Kapazitäten
Method and apparatus for measuring capacities of low value

(30) Priorité: 03.02.1989 FR 8901784
(43) Date de publication de la demande: 08.08.1990
(73) Titulaire: CENTRE NATIONAL DE LA RECHERCHE SCIENTIFIQUE (CNRS), 75700 Paris Cedex 07 (FR)
(72) Inventeur: Haddara, Hisham, Heliopolis Cairo (EG); Cristoloveanu, Sorin, F-38170 Seyssinet (FR); Bouro, Luc, F-38100 Grenoble (FR)
(74) Mandataire: de Beaumont, Michel

(56) Documents cités:
- RADIO FERNSEHEN ELEKTRONIK
- REVIEW OF SCIENTIFIC INSTRUMENTS
- ELECTRONIQUE APPLICATIONS

## Description

### PROCÉDÉ ET APPAREIL DE MESURE DE CAPACITÉS DE FAIBLE VALEUR

La présente invention concerne la mesure de capacités, chaque capacité étant considérée ci-après comme constituée d'une capacité pure de valeur C en parallèle sur une résistance de forte valeur, de conductance G, ces capacités et résistances étant variables en fonction de la tension et de la fréquence qui leur sont appliquées.

La présente invention vise plus particulièrement la mesure de capacités de l'ordre de quelques picofarads ou inférieures au picofarad à des fréquences pouvant varier dans un très large domaine, depuis des valeurs très faibles de l'ordre de quelques dixièmes de Hz jusqu'à des valeurs élevées de l'ordre de quelques mégahertz.

Le problème de la mesure de telles capacités dans un tel spectre de fréquence se pose notamment pour la caractérisation des structures métal/isolant/semiconducteur (MOS et MIS). En particulier pour les circuits intégrés on peut déduire de la valeur des capacités grille-source, grille-drain ou grille-substrat d'un transistor MOS la qualité des interfaces silicium/oxyde de silicium. A l'heure actuelle, étant donné que l'on n'arrive pas à mesurer rapidement et avec précision des capacités de valeurs aussi faibles que celles mentionnées ci-dessus et correspondant à des capacités de grille de transistors MOS, on est amené à prévoir sur des circuits intégrés des zones de test où des capacités de beaucoup plus grande valeur que celles d'un transistor réel sont formées et mesurées. Ensuite, on est obligé d'agir par extrapolation en utilisant un facteur d'échelle pour déterminer les capacités de transistors réels. Ceci présente l'inconvénient que les valeurs obtenues pour les transistors réels ne sont pas nécessairement exactes, les facteurs d'échelle n'étant pas simples à déterminer. Un autre inconvénient est que cela exige de prévoir sur une plaquette de circuit intégré une zone de condensateur test de relativement grande surface pour atteindre des valeurs mesurables ce qui nuit aux exigences de miniaturisation des circuits intégrés.

A l'heure actuelle, pour mesurer des capacités de très petites valeurs, on emploie généralement l'un ou l'autre de deux procédés.

Le premier procédé consiste à insérer l'impédance inconnue dans un pont de mesure et à déterminer sa valeur par équilibrage du pont. Ce procédé, relativement précis, souffre de l'inconvénient d'être relativement long à mettre en oeuvre même avec des méthodes automatisées et, dans la gamme des appareils actuellement connus, il ne permet pas de mesurer avec une précision et une rapidité suffisantes des capacités de valeur inférieure à la dizaine de picofarads.

Un autre de l'art antérieur, décrit dans Electronique Applications, 1983, N° 28, pages 61-65, permettant des mesures beaucoup plus rapides consiste à appliquer au condensateur à mesurer une tension constituée de la somme d'une tension oontinue et d'une tension sinusoidale de faible amplitude devant celle de la tension oontinue. Le courant dans la capacité (comprenant en fait, en parallèle, une capacité pure et une résistance de forte valeur) est détecté par un convertisseur tension-courant dont la sortie est reliée à un détecteur synchrone qui permet d'une façon bien connue de déterminer la variation d'amplitude et le déphasage du courant sinusoïdal détecté par rapport à la tension appliquée. On peut en déduire directement la valeur de la capacité et de la résistance. Un inconvénient de ce procédé est que, en pratique, il s'avère peu précis à basse fréquence, notamment à des fréquences inférieures à la dizaine de Hz et qu'un détecteur synchrone n'est en fait pas un dispositif très large bande mais un dispositif qui doit être largement modifié pour fonctionner à de très faibles (quelques dixièmes de Hz) ou de très fortes (quelques MHz) fréquences. On arrive donc à des appareils coûteux et peu précis. En outre, on notera qu'un système à détecteur synchrone ne fonctionne pas convenablement pour certaines valeurs particulières du déphasage. Ces limitations sont particulièrement gênantes dans le cas de la mesure de structures MOS quand Cω est très inférieur ou très supérieur à G (ω étant 2π fois la fréquence d'analyse) et ceci en raison de la résolution insuffisante du déphasage (au mieux 0,1°).

Dans les procédés susmentionnés la tension continue appliquée se présente parfois sous la forme d'une tension lentement variable, par exemple une tension triangulaire de grande amplitude.

Pour toutes ces raisons, on recherche un nouvel appareil permettant de mesurer avec précision et rapidité la valeur de faibles capacités dans une large plage de fréquence.

Pour atteindre cet objet, la présente invention prévoit un procédé de mesure d'une impédance comprenant l'association en parallèle d'une capacité de faible valeur et d'une résistance de faible conductance consistant à appliquer à cette impédance une tension continue et un petit signal de forme triangulaire, et à mesurer le courant en au moins deux points déterminés de chaque alternance du triangle pour déterminer la pente et la valeur à l'origine d'un segment de courant correspondant à cette alternance, la pente correspondant à la conductance et la valeur à l'origine correspondant à la capacité parallèle de l'impédance.

Un appareil de mise en oeuvre de ce procédé comprend selon l'invention :
- une source de tension continue réglable en amplitude,
- une source de signal triangulaire de faible valeur devant le signal continu et réglable en fréquence,
- un échantillon à mesurer recevant la somme des signaux des deux sources,
- un convertisseur courant-tension recevant le courant dans l'échantillon,
- un échantillonneur-bloqueur pour détecter et mémoriser des valeurs du signal de sortie du convertisseur, et
- un circuit de commande pour commander l'échantillonneur-bloqueur en relation avec le passage du signal triangulaire par deux valeurs déterminées lors de chaque alternance.

Un avantage du procédé selon la présente invention est qu'il se prête à être mis en oeuvre par un appareillage particulièrement simple et fonctionnant sans difficulté dans une très large plage de fréquence.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1A représente l'allure d'une tension appliquée selon la présente invention ;
la figure 1B représente l'allure du courant correspondant à ladite tension ;
la figure 2 représente un schéma général sous forme de blocs d'un appareil selon un mode de réalisation de la présente invention ; et
les figures 3A et 3B représentent l'allure des impédances équivalentes à une capacité MOS et les capacité et conductance mesurées selon la présente invention.

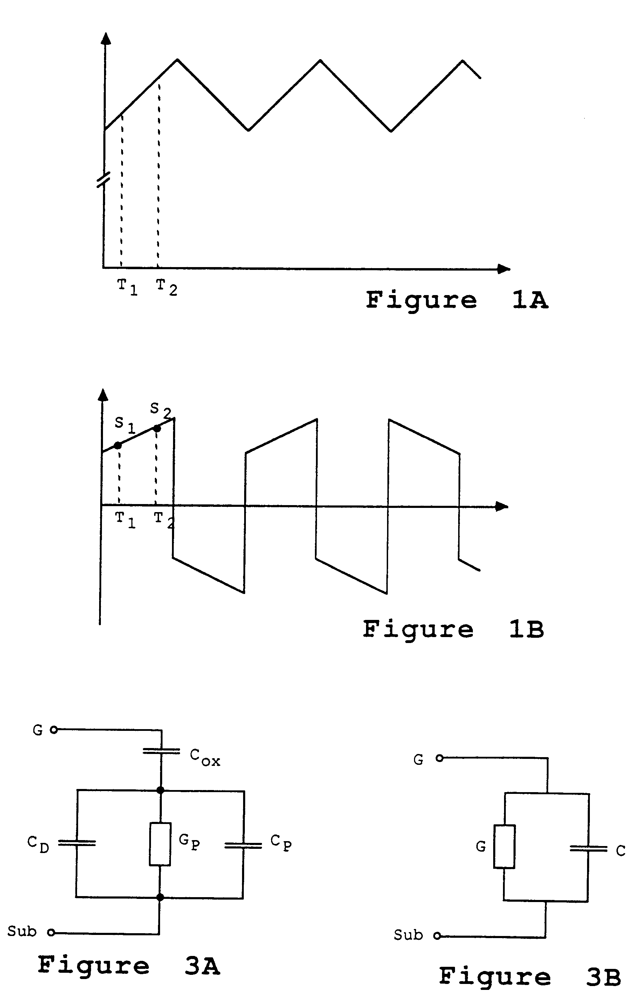

Comme l'illustre la figure 1A, la présente invention prévoit d'appliquer à un circuit élémentaire dont le schéma équivalent comprend en parallèle une capacité de valeur C et une résistance de conductance G une tension constituée de la superposition d'une tension continue et d'un signal triangulaire. Il en résulte que le courant a l'allure représentée en figure 1B. Ce courant total a une valeur i(t) = C(dv/dt) + Gv. Si l'on pose v(t) = at (tandis que le signal triangulaire est croissant), on a i(t) = aC + Gat. Ainsi, la variation de i(t) pendant l'alternance considérée est représentée par une ligne droite dont la pente fournit la conductance G et dont l'ordonnée à l'origine donne la capacité C. Dans l'autre moitié de la période, où v(t) = -at, on obtient une autre droite de pente négative, i(t) = - aC - Gat.

Ainsi, à chaque alternance du courant, en mesurant deux points de cette alternance ayant une distance connue par rapport au début de l'alternance, on peut déterminer la pente et l'ordonnée à l'origine à partir du début de l'alternance. L'expérience montre que l'on obtient des résultats particulièrement satisfaisants en combinant les résultats obtenus pour des alternances positives et négatives.

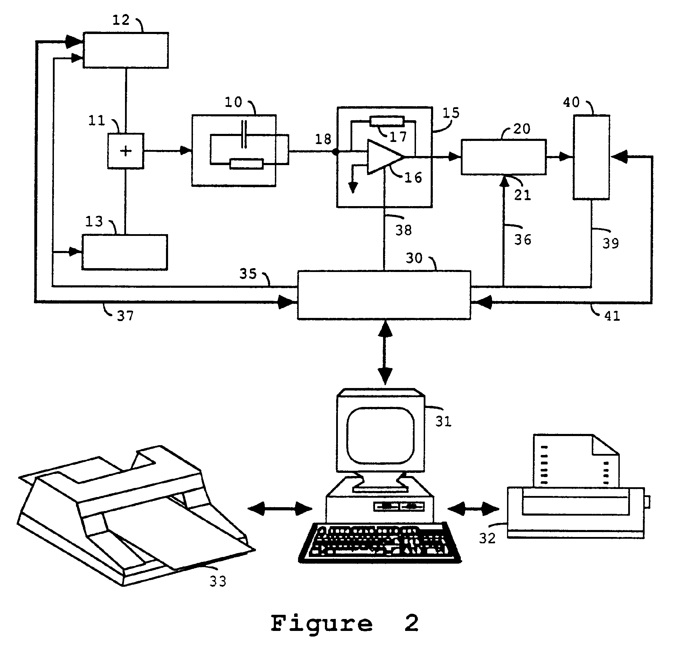

Ce procédé conduit à des calculs très simples et l'appareillage pour le réaliser peut également être très simple comme le montre l'exemple de la figure 2. Dans cette figure, la capacité à mesurer est illustrée dans le bloc 10. Ce bloc 10 reçoit sur l'une de ses bornes la sortie d'un additionneur 11 recevant lui-même, d'une part, la sortie d'une source de tension continue 12, d'autre part, la sortie d'une source de signal triangulaire 13. La deuxième borne de l'échantillon 10 est connectée à l'entrée d'un convertisseur courant-tension 15 comprenant par exemple un amplificateur opérationnel 16 et une résistance de réaction 17. La première entrée de cet amplificateur opérationnel est connectée à la sortie de l'échantillon 10, la deuxième entrée est reliée à la masse et la sortie est reliée à la première entrée par la résistance 17. Ainsi, la première entrée 18 de l'amplificateur opérationnel constituera une masse virtuelle et l'on peut effectivement considérer que l'échantillon 10 est relié entre la source de tension souhaitée et la masse.

La tension de sortie du convertisseur 15 est envoyée à un échantillonneur-bloqueur 20 qui mémorise et accumule les informations de sortie du convertisseur recueillies à des instants donnés par une entrée de commande 21. Un contrôleur 30 assure, sous la commande d'un ordinateur 31, la synchronisation et la commande de l'ensemble du système. L'ordinateur 31 peut lui-même être par exemple relié à une imprimante 32 et à un traceur de courbe 33.

Le contrôleur 30 est relié à la source de tension triangulaire 13 par un bus bidirectionnel 35 pour permettre la détection du passage de la tension par deux valeurs déterminées, par exemple les valeurs S1 et S2 correspondant aux instants T1 et T2 illustrés en figures 1A et 1B. En outre, le contrôleur 30 est relié à l'entrée de commande 21 de l'échantillonneur-bloqueur 20 par une ligne 36 pour déterminer la prise d'échantillon aux instants T1 et T2 de chaque alternance du signal triangulaire. On a également représenté d'autres connexions du contrôleur 30 à savoir : une ligne 37 vers la source de tension continue 12 pour fixer son amplitude ; une liaison 38 vers le convertisseur courant-tension 15 pour fixer son gain (par exemple en réglant la résistance 17) ; et une liaison 39 vers un convertisseur analogique/numérique 40 permettant de numériser les signaux de sortie de l'échantillonneur-bloqueur 20 pour traitement par le contrôleur 30 de l'ordinateur 31, la liaison entre le convertisseur analogique/numérique 40 et le contrôleur 30 étant assurée par un bus 41.

On notera qu'un avantage du procédé selon la présente invention et d'un dispositif de mise en oeuvre tel qu'illustré en figure 2 est que ce dispositif se prête tout particulièrement à fonctionner sur une large plage de fréquences. En effet, un convertisseur courant-tension du type illustré ne présente pas avec les composants électroniques actuellement disponibles de problèmes particuliers de fonctionnement à des fréquences basses de l'ordre de 0,1 Hz pas plus qu'à des fréquences élevées de l'ordre de quelques MHz. Il sera toutefois souhaitable de prévoir un réglage du gain qui varie avec la fréquence. De même, un échantillonneur-bloqueur 20 est un dispositif qui fonctionne sans difficulté à haute et basse fréquence. C'est là un avantage important de la présente invention par rapport à la structure de l'art antérieur utilisant un détecteur synchrone qui, s'il est adapté à fonctionner à haute fréquence, fonctionnera difficilement à basse fréquence.

Bien entendu, le dispositif de la figure 2 ne constitue qu'un exemple de dispositif de mise en oeuvre du procédé selon l'invention dont diverses variantes apparaîtront à l'homme de l'art. Par exemple, au lieu de réaliser une mesure absolue de la valeur de la capacité et de la conductance de l'échantillon 10, on pourra placer en parallèle avec cet échantillon 10 un échantillon de référence dont les valeurs de capacité et de conductance sont connues et opérer par comparaison.

La figure 3A représente un exemple d'échantillon que la présente invention permet de mesurer, à savoir la capacité grille-substrat (G-Sub) d'un transistor MOS. Cette capacité se présente physiquement sous la forme illustrée en figure 3A, et comprend une capacité série Cₒₓ reliée au montage en parallèle de deux capacités C_{D} et C_{P} et d'une conductance G_{P}, où :
- Cₒₓ: : capacité de l'oxyde de grille
- C_{D}: : capacité de la zone déserte
- C_{P}: : capacité relative aux états d'interface
- G_{P}: : conductance relative aux états d'interface.

Selon l'invention, on mesure la capacité C et la conductance G d'un échantillon correspondant au schéma équivalent illustré en figure 3B. C'est également ce type de mesure que l'on effectue quand on utilise une mesure par des signaux sinusoïdaux et une détection synchrone. Il importe, à partir des valeurs de G et C de remonter en particulier aux valeurs de G_{P} et C_{P} dont la variation avec la tension de grille du transistor et la fréquence caractérisent des paramètres d'un transistor MOS. On notera que les règles mathématiques permettant de passer de G et C à G_{P} et C_{P} diffèrent dans le cas où on utilise des signaux sinusoïdaux et dans le cas où on utilise des signaux de forme triangulaire selon l'invention. En d'autres termes, les valeurs de G et de C que l'on mesure selon l'invention ne sont pas identiques à celles que l'on mesure dans le cas d'application de signaux harmoniques mais on pourra néanmoins de façon équivalente remonter aux mêmes valeurs de G_{P} en C_{P} en utilisant bien entendu des équations différentes.

## Revendications

1. Procédé de mesure d'une impédance comprenant l'association en parallèle d'une capacité de faible valeur et d'une résistance de faible conductance consistant à appliquer à cette impédance une tension continue et un petit signal d'amplitude variable, caractérisé en ce que :
le petit signal est une tension de forme triangulaire,
le courant en au moins deux points déterminés de chaque alternance de la tension triangulaire appliquée est mesuré, et la pente et la valeur à l'origine d'une ligne imaginaire, passant par les valeurs de oourant ainsi mesurées, sont déterminées, et
la conductance et la capacité parallèle de l'impédance sont calculées à partir de ladite pente, de ladite valeur à l'origine et de la pente de la tension triangulaire.

2. Procédé selon la revendication 1, caractérisé en ce que les mesures de courant sont répétées sur un grand nombre de périodes du signal triangulaire et moyennées.

3. Procédé selon la revendication 1, caractérisé en ce qu'il est alternativement appliqué à une impédance inconnue et à une impédance de référence.

4. Appareil de mesure d'une impédance comprenant :
- une souroe de tension oontinue (12) réglable en amplitude,
- une source de signal alternatif (13) de faible valeur devant le signal continu et réglable en fréquence,
- un échantillon à mesurer (10) comprenant l'association en parallèle d'une capacité de faible valeur et d'une résistance de faible conductance recevant la somme des signaux des deux sources,
- un convertisseur courant-tension (15) recevant le courant traversant l'échantillon, caractérisé en ce que la source de signal alternatif est une souroe de tension triangulaire et en ce qu'il comprend en outre :
- un échantillonneur-bloqueur (20) pour détecter et mémoriser des valeurs du signal de sortie du convertisseur,
- un circuit de commande (30) pour commander l'échantillonneur-bloqueur en relation avec le passage du signal triangulaire par deux valeurs déterminées lors de chaque alternance.

5. Appareil selon la revendication 1, caractérisé en ce que le contrôleur comprend en outre des moyens (35,38) pour modifier la fréquence du signal triangulaire et pour modifier corrélativement le gain du convertisseur.

## Patentansprüche

1. Verfahren zum Messen einer Impedanz aus einer Parallelschaltung eines Kondensators geringen Kapazitätswertes und eines Widerstandes mit geringem Leitwert, wobei an diese Impedanz eine Gleichspannung und ein überlagertes schwachen Signal variabler Amplitude angelegt wird, dadurch gekennzeichnet, daß
- das schwache Signal eine Spannung mit einem Dreiecksverlauf ist,
- der Strom an zumindest zwei bestimmten Punkten in jeder Halbperiode der angelegten Dreiecksspannung gemessen wird, und die Steigung sowie der Wert am Ursprung einer imaginären Linie, die durch die derart bestimmten Strommeßwerte verläuft, bestimmt werden, und
- der Leitwert und der parallele Kapazitätswert der Impedanz aus dieser Steigung, dem Wert am Ursprung sowie der Steigung der Dreiecksspannung berechnet werden.

2. Verfahren nach Anspruch 1, dadurch gekennzeichnet, daß die Strommessungen über eine große Periodenanzahl des Dreieckssignales wiederholt und gemittelt werden.

3. Verfahren nach Anspruch 1, dadurch gekennzeichnet, daß es alternativ auf eine unbekannte Impedanz und auf eine Referenzimpedanz angewandt wird.

4. Gerät zum Messen einer Impedanz mit:
- einer Quelle für eine Gleichspannung (12), die in der Amplitude regelbar ist,
- einer Quelle eines Wechselsignals (13) mit einem gegenüber dem Gleichsignal kleinen Wert und mit regelbarer Frequenz,
- einer zu vermessenden Probenschaltung (10) aus einer Parallelschaltung eines Kondensators geringen Kapazitätswertes und eines Widerstandes mit geringem Leitwert, die die Summe der Signale der beiden Quellen empfängt,
- einen Strom/Spannungswandler (15), der den Strom durch die Probenschaltung empfängt,
dadurch gekennzeichnet, daß die Quelle des Wechselsignals eine Quelle für eine dreieckförmige Spannung ist, und daß die Vorrichtung ferner
- eine Abtast- und Halteschaltung (20) zum Detektieren und Speichern der Werte des Ausgangssignales des Wandlers und
- eine Steuerschaltung (30) zum Steuern der Abtast- und Halteschaltung in bezug zu dem Durchgang des Dreieckssignals durch zwei vorbestimmte Werte während jeder Halbperiode aufweist.

5. Gerät nach Anspruch 1, dadurch gekennzeichnet, daß die Steuerschaltung zusätzlich Einrichtungen (35, 38) aufweist, um die Frequenz des Dreieckssignales und in Korrelation damit den Gewinn des Wandlers zu modifizieren.

## Claims

1. A method for measuring an impedance comprising the parallel association of a low value capacitor and a low conductance resistor, consisting in applying to said impedance a d.c. voltage and a small signal having a variable amplitude, characterized in that:
the small signal is a voltage having a triangular waveform,
the current is measured at at least two predetermined points of each half-period of the applied triangle-shaped voltage, and the slope and the value at the origin of an imaginary line crossing the current values thus measured, are defined, and
the condunctance and parallel capacitance of the impedance are calculated from said slope, from said value at the origin and from said slope of the triangle-shaped voltage.

2. The method of claim 1, characterized in that the current measurements are repeated over a large number of periods of the triangle-shaped signal and are averaged.

3. The method of claim 1, characterized in that it is alternatively applied to an unknown impedance and to a reference impedance.

4. An apparatus for measuring an impedance, including :
- a d.c voltage source (12) having an adjustable amplitude,
- an a.c. signal source (13) having a low value with respect to the d.c. signal and an adjustable frequency,
- a sample (10) to be measured, comprising the parallel association of a low value capacitor and a low conductance resistor, receiving the sum of the signals of the two sources,
- a current-voltage converter (15) receiving the current flowing through the sample, characterized in that the a.c. signal source is a triangle-shaped voltage source and in that it further comprises:
- a sample and hold circuit (20) to detect and memorize values of the converter output signal,
- a control circuit (30) to control the sample and hold circuit with reference to the crossing by the triangle-shaped signal of two predetermined values during each half-period.

5. The apparatus of claim 1, wherein said control circuit further includes means (35, 38) to modify the frequency of the triangle-shaped signal and to correlatively modify the converter gain.
